# EUROPÄISCHE PATENTSCHRIFT

(11) **EP 1 391 535 B1**
(45) Veröffentlichungstag und Bekanntmachung des Hinweises auf die Patenterteilung: **04.07.2007**
(21) Anmeldenummer: 03008415.6
(22) Anmeldetag: 11.04.2003
(51) Int. Cl.: C23C 16/04, B05D 7/22, B05D 7/24

(54) **Vorrichtung zum Aufnehmen und Vakuumabdichten eines Behältnisses mit einer Öffnung**
Device for receiving and vacuum sealing of a container having an opening
Dispositif pour la réception et pour rendre étanche à vide d'un récipient avec une ouverture

(30) Priorität: 15.05.2002 DE 10221461
(43) Veröffentlichungstag der Anmeldung: 25.02.2004
(73) Patentinhaber: SIG Technology AG, 8212 Neuhausen am Rheinfall (CH)
(72) Erfinder: Lüttringhaus-Henkel, Andreas, 64289 Darmstadt (DE); Bicker, Matthias, Dr., 55126 Mainz (DE); Behle, Stephan, Dr., 55278 Hahnheim (DE); Arnold, Gregor, 55294 Bodenheim (DE)
(74) Vertreter: Herden, Andreas F.

(56) Entgegenhaltungen:
- WO-A-99/17334
- DE-B- 1 019 004
- DE-U- 8 915 239
- US-B1- 6 242 053

## Beschreibung

Die Erfindung betrifft eine Vorrichtung zum Aufnehmen und Vakuumabdichten eines Behältnisses mit einer Öffnung, insbesondere eines flaschenförmigen Behältnisses mit einem eine Ausgießöffnung aufweisenden Hals.

Derartige Vorrichtungen finden ihre Anwendung insbesondere bei der Innen- und/oder Außenbeschichtung von Behältnissen oder Hohlkörpern, wie beispielsweise Kunststoffhohlbehältern, im Lebensmittelbereich und/oder auf dem medizinischen Gebiet. Auf diesen Gebieten werden beispielsweise Kunststoffhohlbehälter mittels eines Abscheidungsverfahrens, insbesondere mittels eines Plasmaimpuls-induzierten chemischen Dampfphasenabscheidungsverfahren (PICVD, Plasma Impuls Chemical Vapour Deposition) innen und/oder außen mit einer Barriereschicht versehen, die gegenüber chemischen Substanzen, aber auch gegenüber Temperaturwechseln äußerst beständig ist, eine hohe Korrosionswiderstandsfähigkeit aufweist sowie sich einer guten Haftbeständigkeit auszeichnet.

Hierzu werden die Hohlbehälter üblicherweise im Labormaßstab in eine Aufnahme eingeschraubt und am Stirnrand der Behälter- und/oder Ausgießöffnung abgedichtet, so dass eine Beschichtung im Innern ermöglicht ist. Nach dem zusätzlichen Überstülpen einer vakuumdichten Glocke kann man die Hohlkörper nicht nur innen sondern auch außen evakuieren. Nach dem Vakuumabdichten kann somit der für innen und/oder außen vorgesehene Beschichtungsvorgang durchgeführt werden.

Aus der deutschen Offenlegungsschrift DE-A-1 99 57 744 ist eine Vorrichtung zum Abdichten des Stirnrandes eines Behälterhalses bekannt. Zur Abdichtung des Stirnrandes ist demgemäß vorgesehen, die Vorrichtung mit einem eine Abdichtlippe aufweisenden Abdeckring aus elastischem Material bereitzustellen, wobei der Abdeckring von einer koaxial zu diesem angeordneten Ringaufnahme derart gehalten ist, dass der Stirnrand des Halses eines zu beschichtenden Behältnisses zur Abdichtung gegen die Abdichtlippe unter Verformung derselben drückbar ist.

Einrichtungen zum entsprechenden Halten des Behältnisses sowie Antriebsmittel, um das Behältnis mit seinem Stirnrand in Richtung auf die stationär angeordnete Ringaufnahme derart zu bewegen, dass der Stirnrand vor der Berührung des Abdeckringes gegen die Abdichtlippe drückt und diese derart verformt, dass der gesamte Stirnrand zur Vakuumabdichtung von der Abdichtlippe bedeckt ist, sind der Offenlegungsschrift jedoch nicht zu entnehmen.

Die US-B1-6242053 zeigt einen Prozeß und eine Vorrichtung zum Beschichten der Oberflächen eines hohlen Objektes, insbesondere eines hohlen Objektes mit einer verschließbaren Öffnung, mittels Plasmabeschichtung. Beispielsweise wird dabei der Behälter mittels zweier gegenläufiger und zueinander diametral gegenüber angeordneter Schieber, welche gegen die schräge Unterfläche des Behälterkragens gleiten, in eine in Richtung des Kopfteils gerichtete Vorzugsrichtung verschoben. Hierbei wird die Dichtfläche des Behälters gegen ein Dichtungselement vakuumdichtend gedrückt.

In der WO-A-9917334 wird eine Vorrichtung zum Behandeln der inneren Oberflächen einer Flasche in einem Plasmaprozeß beschrieben, welche eine Vakuumkammer, einen Mikrowelleneinschluß mit einem Mikrowellengenerator, Evakuierungsmittel und Gaszufuhrmittel umfaßt. Die Vorrichtung weist dabei Mittel zum Halten und zum Abdichten des Behälters auf. Die Mittel zum Halten werden dabei seitlich an den Flaschenhals geführt.

DE-U-8915239, beschreibt eine Vorrichtung zur Aufnahme eines Pumpstengels von Gasdrucklampen mit einer im Arbeitszyklus den Pumpstengel umschließenden Stopfbuchse, die in Verbindung mit einer innerhalb eines Gehäuses angeordneten Halterung durch die mit Druck auf die Stopfbuchse einwirkende Kraft einen gasdichten und druckfesten Verschluß bildet.

Aufgabe der Erfindung ist es, eine gattungsbildende Vorrichtung zum Aufnehmen und Vakuumabdichten derart weiterzubilden, dass die Vorgänge Aufnehmen, Abdichten und Fixieren eines Hohlkörpers auf einfache Weise automatisierbar sind und die Vorrichtung somit für einen kostengünstigen industriellen Beschichtungsprozess, insbesondere auch für eine Beschichtung in einer Maschine mit vielen Einzelbeschichtungsplätzen verwendbar ist.

Die erfindungsgemäße Lösung der Aufgabe ist bereits durch eine Vorrichtung mit den Merkmalen des Anspruchs 1 und durch eine Anlage zum Vakuumbeschichten mit den Merkmalen des Anspruchs 12 gegeben.

Vorteilhafte und/oder bevorzugte Ausführungsformen oder Weiterbildungen sind Gegenstand der jeweiligen Unteransprüche.

Ein wesentlicher mit der erfindungsgemäßen Vorrichtung erreichter Vorteil besteht insbesondere darin, dass lediglich ein Bewegungsvorgang zum Aufnehmen, Fixieren und Abdichten eines Behältnisses erforderlich ist. Die Fixierung findet hierbei durch die mit der Aufnahme zusammenwirkenden Einspannelemente statt, wobei parallel dazu die Öffnung im eingeführten Endzustand des Behältnisses, also im fixierten Zustand gleichzeitig abgedichtet ist. Die erfindungsgemäße Vorrichtung gewährleistet somit einen auf einfachste Weise automatisierbaren Aufnahme- und Abdichtungsablauf entlang lediglich einer Achse, welche der Einführrichtung des Behältnisses entspricht. Auf aufwendige Rotationsbewegungen, beispielsweise zum Verschrauben des Behältnisses und/oder Antriebsbewegungen in einer Richtung quer zur Einführrichtung, beispielsweise zum Fixieren des Behältnisses kann somit verzichtet werden kann.

Erfindungsgemäß ist die Vorrichtung zum Aufnehmen und Vakuumabdichten wenigstens eines Behältnisses mit einem an die Öffnung angrenzenden, halsförmig ausgebildeten Wandungsbereichs (3a) ausgebildet.

Es sind eine Vielzahl von einander beabstandeten Einspannelementen vorgesehen, insbesondere um den Einführbereich herum angeordnet, die jeweils in einer Richtung quer zur Einführrichtung des Behältnisses in den Einführbereich bringbar sind, um ein wesentlich verbessertes Einführen des Behältnishalses und ein definiertes Fixieren des Behältnisses zu gewährleisten.

In vorteilhafter Fortführung der erfindungsgemäßen Vorrichtung ist darüber hinaus vorgesehen, dass die Käfigeinrichtung einen entlang der Einführrichtung verschiebbaren Schlitten und eine stationär angeordnete Führungsoberfläche umfasst, zwischen denen die Einspannelemente gehalten sind. Hierdurch lässt sich auf einfache Weise eine störungsunanfällige, definierte Führung des wenigstens einen Einspannelements gewährleisten.

Als Einspannelement ist in bevorzugter Weiterbildung, um ein Einführen des Behältnisses ohne ein Verklemmen sicherzustellen, insbesondere eine Kugel vorgesehen.

Gemäß einer weiteren bevorzugten Weiterbildung, insbesondere um die zur Herstellung der erfindungsgemäßen Vorrichtung notwendigen Komponenten und somit die Kosten zu reduzieren ist vorgesehen, die Oberfläche zur Führung der Einspannelemente als Teil eines den Einführbereich begrenzenden Aufnahmekörpers, wie insbesondere eines den Einführbereich begrenzenden ringförmigen oder zylinderförmigen Körpers auszubilden.

In besonders einfacher und zweckmäßiger Weiterbildung sieht die Erfindung ferner vor, dass die Führungsoberfläche eine Verjüngung des Einführbereichs in Einführrichtung bewirkt.

Zum sicheren Fixieren des Behältnisses im eingeführten Zustand ist darüber hinaus vorgeschlagen, die Käfigeinrichtung und/oder die Einspannelemente derart auszubilden, dass die Einspannelemente in am Hals des Behältnisses ausgebildete Nuten und/oder Vorsprünge, insbesondere in ein Außengewinde einrastbar sind. Zur Evakuierung im Innern des Behältnisses ist der Einführbereich in Bezug auf die Einführrichtung in zweckmäßiger Weise ferner zur Aufnahme eines rückseitig einführbaren Vakuumsystems ausgebildet.

Vorteilhafter Weise umfasst die erfindungsgemäße Vorrichtung ferner eine dem einzuführenden Behältnis zugeordneten Mitnahmeeinrichtung zur Kraftbeaufschlagung der Käfigeinrichtung bei Bewegung des Behältnisses in Einführrichtung. Hierdurch ist gewährleistet, dass über die Bewegungssteuerung des Behältnisses selbst der Fixier- und Abdichtvorgang unmittelbar kontrolliert wird.

In besonders bevorzugter Weiterbildung ist hierzu erfindungsgemäß vorgesehen, dass die Käfigeinrichtung eine den Einführbereich wenigstens teilweise umlaufende Mitnahmeeinrichtung derart umfasst, das die Kraftbeaufschlagung mittels einer am Hals des Behältnisses ausgebildeten Ringschulter und/oder eines am Hals ausgebildeten Vorsprungs aufbringbar ist.

Um darüber hinaus eine Beschichtung der äußeren Oberfläche des Behältnisses vorzunehmen, ist in praktischer Weiterbildung ferner vorgesehen, die erfindungsgemäße Vorrichtung mit einer über das einführbare Behältnis stülpbaren Vakuumglocke auszubilden, um eine Evakuierung auch außerhalb des Behältnisses durchzuführen.

Hierfür ist in zweckmäßiger Weise ferner vorgeschlagen, der Käfigeinrichtung eine der Glocke und/oder von außen einbringbaren Führungselementen zugeordneten Mitnahmeeinrichtung zuzuweisen, die bei Bewegung der Glocke und/oder von außen einbringbaren Führungselementen in Einführrichtung die Kraftbeaufschlagung der Käfigeinrichtung zur Führung der Einspannelemente bewirkt.

Um ein zügiges Beschicken von einzuführenden und somit ein für die industrielle Anwendung im wesentlichen störungsfreies Austauschen von nacheinander einzuführenden Behältnissen zu gewährleisten, ist ferner in praktischer Weiterbildung vorgesehen, die Käfigeinrichtung unter einer der Einführrichtung entgegengesetzt gerichteten Vorspannung zu halten. Insbesondere bei Einsatz von Kugeln als Einspann- und/oder Sperrelementen ist hierbei in wirksamer Weise sichergestellt, dass auch ein einfaches Entformen des Behältnishalses bei Bewegung des Behältnisses entgegen der Einführrichtung aus dem Einführbereich gewährleistet ist.

Die Erfindung schlägt ferner eine Anlage zum Vakuumbeschichten der inneren und/oder äußeren Oberflächen wenigstens eines Behältnisses mit wenigstens einer Vorrichtung zum Aufnehmen und Vakuumabdichten vor. Aufgrund der erfindungsgemäßen Aufnahme und Abdichtvorrichtung, welche eine äußerst geringe Bauhöhe benötigt, werden auftretende Störungen in Bezug auf das plasmaerzeugende Mikrowellenfeld einer derartigen Anlage zum Vakuumbeschichten wesentlich minimiert.

Vorzugsweise umfasst die Vakuumbeschichtungsanlage hierbei eine Vielzahl der erfindungsgemäßen Vorrichtungen, um insbesondere für eine Massenfertigung eine Vielzahl von Einzelbeschichtungsplätzen parallel zur Verfügung zu stellen. Eine zur äußeren Beschichtung der Hohlkörper notwendige Vakuumglocke ist hierbei ferner bevorzugt derart ausgebildet, dass diese über alle Einzelbeschichtungsplätze gemeinsam stülpbar ist.

Die Erfindung wird nachfolgend beispielhaft anhand einer bevorzugten Ausführungsform der erfindungsgemäßen Aufnahme- und Abdichtvorrichtung unter Bezugnahme auf die beigefügten Zeichnungen detaillierter beschrieben.

In den Zeichnungen zeigen:
- Fig. 1: einen Aufriss durch Teile einer erfindungsgemäße Aufnahme- und Abdichtvorrichtung mit einer in die Vorrichtung bereits eingesteckten jedoch noch nicht fixierten und abgedichteten Flasche,
- Fig. 2: einen Aufriss der Vorrichtung gemäß Fig. 1, jedoch mit der Flasche im eingeführten, also fixierten und abgedichteten Endzustand und

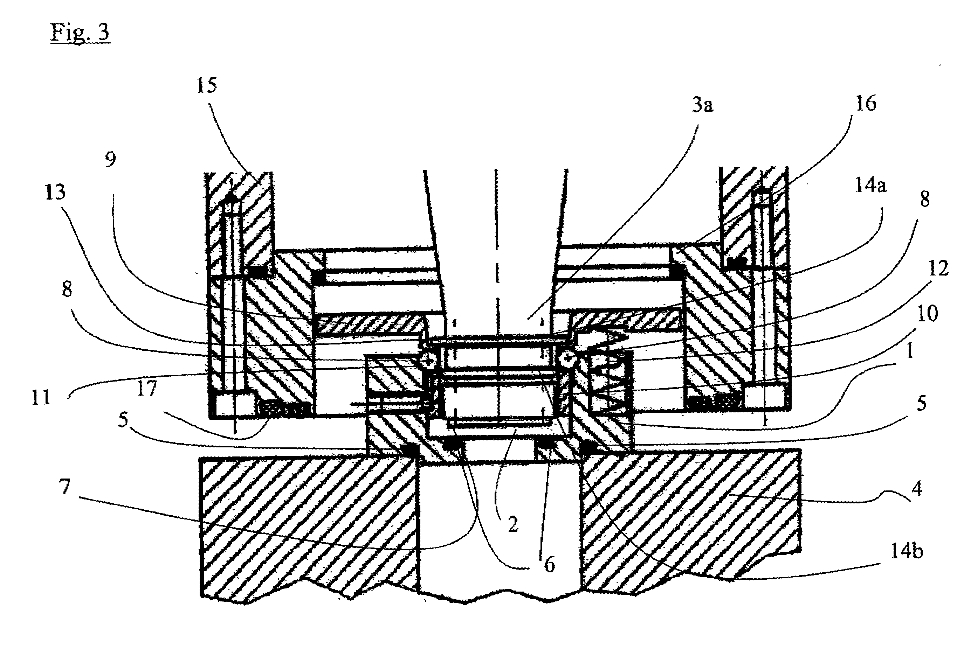

- Fig. 3: zeigt eine vergrößerte Detailansicht von Figur 1.

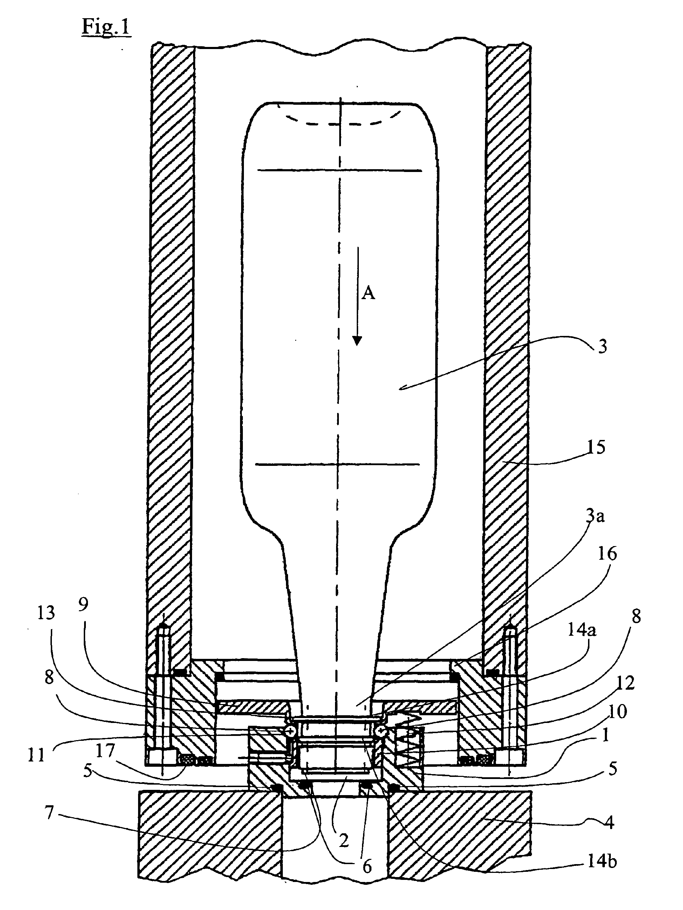

Nachfolgend wird zunächst auf Fig. 1 Bezug genommen, welche einen Aufriss einer erfindungsgemäßen Aufnahme- und Abdichtvorrichtung mit einem noch nicht vollständig in einen Endzustand eingeführten Hohlkörper 3 zeigt.

Die Vorrichtung ist bevorzugt in einer Beschichtungsanlage zur inneren und/oder äußeren Beschichtung, insbesondere durch Auftragen aus einer Gasphase, von insbesondere Kunststoffhohlbehältern im Lebensmittelbereich und/oder auf dem medizinischen Gebiet integriert.

Die Vorrichtung umfasst einen im wesentlichen zylindrisch ausgebildeten Aufnahmekörper 1. Zum Aufnehmen eines halsförmig ausgebildeten, an eine Ausgießöffnung angrenzenden Wandungsbereiches 3a des zu beschichtenden Hohlkörpers 3, weist der Aufnahmekörper 1 in axialer Richtung als Einführbereich eine Aufnahmeöffnung 2 auf, in welche der Hohlkörper 3 in Richtung des Pfeiles A einführbar ist. Der Aufnahmekörper 1 ist im Anlagebereich mit einem rückwärtigen, nicht weiter dargestellten Bereich 4 der Vorrichtung mit Abdichtelementen 5 hermetisch abgeschlossen.

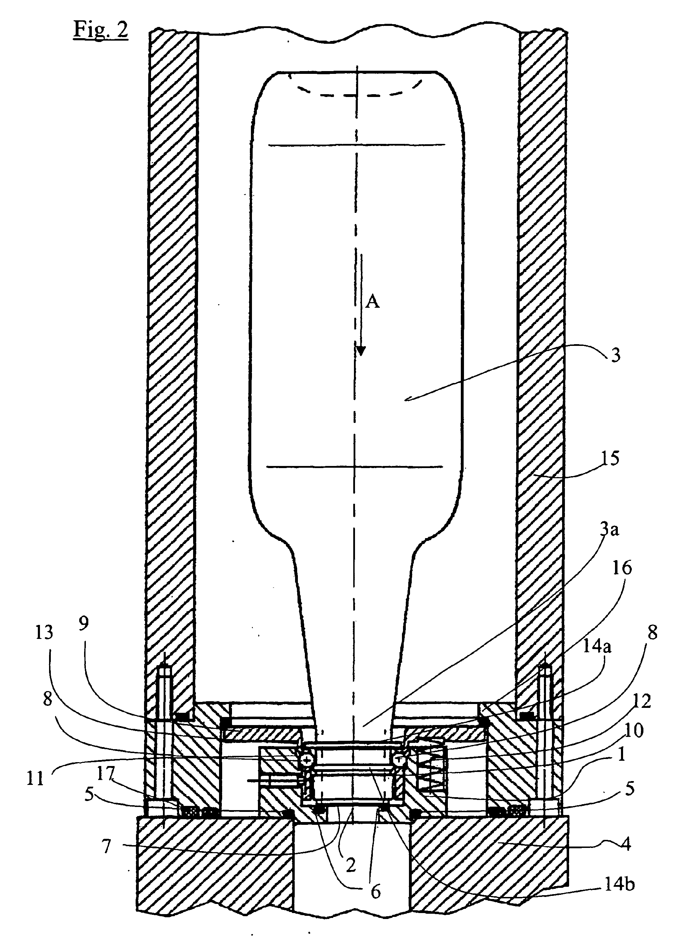

Im vollständig eingeführten Zustand (Fig. 2) des Hohlkörpers 3, der im vorliegenden Fall eine mittels eines PICVD-Verfahrens zu beschichtende Kunststoffflasche ist, kann somit zur inneren Beschichtung des Hohlkörpers 3 entgegen der Einführrichtung des Hohlkörpers 3 vom rückwärtigen Bereich 4 her durch die Aufnahmeöffnung 2 ein nicht dargestelltes Vakuumsystem zur Evakuierung des Behälters angekoppelt werden.

Zur vollständigen Abdichtung des hierbei zu evakuierenden Bereichs gegenüber der Umwelt weist der Aufnahmekörper 1 ferner eine Dichtungseinrichtung 6, beispielsweise in Form eines Dichtungsringes auf, wobei ein die Ausgießöffnung des Halses 3a definierender Stirnrand 7 im eingeführten Endzustand, wie bei Fig. 2 zu sehen, auf die Dichtungseinrichtung 6 drückt, so dass die Ausgießöffnung folglich abgedichtet ist.

Das vorliegende Ausführungsbeispiel umfasst eine Vielzahl von Einspannelementen 8, von denen in der Schnittdarstellung zwei zu sehen sind. Die Einspannelemente sind ferner als Kugeln ausgebildet, um ein Verklemmen des einzuführenden Halses 3a wirksam zu vermeiden.

Die Kugeln 8 sind in einem Käfig beweglich gefangen, wobei insbesondere eine Bewegung in radialer Richtung nach außen sowie nach innen sichergestellt ist. Gemäß dem zugrunde liegenden Ausführungsbeispiel umfasst die Vorrichtung hierzu einen ringförmig ausgebildeten Schlitten 9 mit einem radial ausgebildeten Führungsrand 10, der sich in Einführrichtung in die Aufnahmeöffnung 2 erstreckt und im Wesentlichen an der Innenfläche der Aufnahmeöffnung 2 anliegt. Im Bereich der Einspannelemente 8 weist der Schlitten 9 im Führungsrand 10 ausgebildete Öffnungen auf, die jeweils einen gegenüber den Kugeln 8 etwas geringeren Durchmesser umfassen. Der Aufnahmekörper besitzt ferner an seiner die Aufnahmeöffnung 2 definierenden Innenseite eingearbeitete Absätze 11, derart dass die Einspannelemente 8 somit zwischen den Absätzen 11 und den Führungsrand 10 gefangen sind, wobei sich die Kugeln 8 über die im Führungsrand 10 ausgebildete Öffnungen bis zu einer maximalen Position radial in die Aufnahmeöffnung 2 hinein bewegen können. Die als Führungsoberfläche eingearbeiteten Absätze 11 verjüngen hierbei in bevorzugter Weise den Einführbereich 2 in Einführrichtung, so dass die erwünschte Bewegung der Kugeln 8 zusätzlich unterstützt wird. Der Schlitten 9 liegt an einer Druckfeder 12 an, die im Aufnahmekörper 1 gehalten ist.

Der Hals 3a des Hohlkörpers 3 weist herkömmlicher Weise radial umlaufende Ringe 14a und 14b zur Befestigung eines Deckels wie beispielsweise eines Kronenkorken o.ä. auf. Anstelle der Ringe 14a und 14b kann der Hals 3a zur Befestigung eines Deckels jedoch beispielsweise auch ein Außengewinde oder Hinterschneidungen aufweisen.

Es sei darauf hingewiesen, dass die Aufnahme- und Abdichtvorrichtung auch eine Anzahl von Einführbereichen bzw. Aufnahmeöffnungen 2 zum gleichzeitigen Einführen einer Vielzahl von Behältnisses aufweisen kann.

Insbesondere zur äußeren Vakuumabdichtung des Hohlkörpers 3 umfasst die Vorrichtung darüber hinaus eine Glocke 15, die über den Behälter 3 gestülpt wird. Die Glocke 15 weist praktischerweise radial nach innen gerichtete Absätze 16 auf, so dass bei der Führung der Glocke 15 in Einführrichtung A die Absätze 16 auf dem Schlitten 9, wie bei Fig. 2 zu sehen, in Anlage kommen und diesen entsprechend mit in Einführrichtung A führen. Greifen, wie im vorliegenden Ausführungsbeispiel die Kugeln 8 zwischen den Ringen 14a und 14b ein, wird hierdurch gleichzeitig der Behälter 3 mit in Richtung A gezogen, bis der Stirnrand 7 des Behälters 3 auf der Dichtungseinrichtung 6 abdichtend zur Anlage kommt (Fig. 2). Mit anderen Worten, wird somit durch Absenken der Glocke 15 ein Fixieren und Abdichten der Flasche erreicht, indem die Kugeln 8 mittels des vorstehend beschriebenen Käfigs radial in die Aufnahmeöffnung 2 hinein bewegt werden und den Hals 3a zwischen den Ringen 14a und 14b umschließen, so dass der Behälterhals 3 fixiert ist.

Die Glocke 15 weist ferner Abdichtelemente 17 zur Vakuumabdichtung auf. Zweckmäßigerweise lässt sich über nicht dargestellte Zuleitungen innerhalb einer Vakuumbeschichtungsanlage ferner das Beschichtungssystem ins Innere der Glocke 15 führen.

Insgesamt weist die erfindungsgemäße Vorrichtung folglich eine sehr geringe Bauhöhe auf, wodurch das plasmaerzeugende Mikrowellenfeld bei einer Vakuumbeschichtungsanlage nur geringfügig gestört wird. Ferner ist durch den Einsatz von Kugeln als Einspannelemente sichergestellt, dass sich der zu beschichtende Hohlkörper 3 ohne zu verklemmen in die Aufnahmevorrichtung einbringen und auch wieder entformen läßt.

Eine derartige Vakuumbeschichtungsanlage weist zweckmäßigerweise eine Anzahl von den erfindungsgemäßen Aufnahme- und Vakuumabdichtungsvorrichtungen beispielsweise in Form einer Aneinanderreihung auf, so dass eine automatische Beschickung und folglich Beschichtung von einer Vielzahl von Hohlkörpern parallel durchgeführt werden kann. Eine zur äußeren Beschichtung der Hohlkörper notwendige Vakuumglocke kann hierbei ferner bevorzugt derart ausgebildet sein, dass diese über alle Einzelbeschichtungsplätze gemeinsam stülpbar ist.

Unter Berücksichtigung der vorstehenden Beschreibung lässt sich somit der Vorgang zum Aufnehmen und Vakuumabdichten für eine nachfolgende Innen- und/oder Außenbeschichtung des bzw. der Hohlkörper 3 beispielsweise mittels eines PICVD-Verfahrens basierend auf dem vorliegenden Ausführungsbeispiel wie folgt zusammenfassen.

Der Kunststoffhohlkörper 3 wird in Einführrichtung A in den Einführbereich der Aufnahmeöffnung 2 eingesteckt, jedoch wie bei Fig. 1 zu sehen, noch nicht fixiert und nicht abgedichtet. Zweckmäßigerweise weist der Kunststoffhohlkörper 3 hierbei noch einen Hub von ca. 20 mm auf. Die einspannenden Kugeln 8 sind in dieser Position des Hohlkörpers 3 noch frei beweglich und werden von der einfahrenden Ausgießöffnung bzw. von dem einfahrenden Hals 3a zunächst radial nach außen gedrängt. Zwischen den Ringen 14a und 14b des Halsbereiches 3 können die Kugeln 8 einrasten. Wird der Schlitten 9 nun weiter in Richtung des Aufnahmekörpers 1 gedrückt und also der Rand 10 in die Aufnahmeöffnung 2 weiter hinein verschoben, werden die Sperrkugeln 8 unter Führung der im Aufnahmekörper 1 eingearbeiteten Absätze 11 radial nach innen bewegt und umschließen den Hals 3a zwischen den Ringen 14a und 14b. Durch weiteres Mitnehmen des Schlittens 9, insbesondere, wie vorstehend beschrieben, über den Absatz 16 der Glocke 15, wie bei Fig. 2 zu sehen, wird der Stirnrand 7 der Ausgießöffnung auf die Dichtungseinrichtung 6 gedrückt und somit abgedichtet.

Im vorliegenden Ausführungsbeispiel, also bei Verwendung der Glocke 15 wird das Mitnehmen des Schlittens 9 gegen den durch die Druckfeder 12 erwirkten Federdruck direkt durch die in Einführrichtung bewegte Glocke 15 gesteuert, wobei die zwischen den Ringen 14a und 14b eingreifenden Kugeln 8 die Kunststoffflasche 3 mitnehmen und in Folge der Stirnrand 7 auf die Dichtungseinrichtung 6 gedrückt wird.

In einer alternativen Ausführung ist jedoch auch vorgesehen, dass die Mitnahme des Schlittens 9 und damit der Spann- und Abdichtvorgang durch von außen in die Vorrichtung durchgeführte und entsprechend abgedichtete Stangen erfolgt. Die Stangen werden hierbei zweckmäßigerweise durch Pneumatikzylinder oder mechanische Steuerkurven betätigt.

## Patentansprüche

1. Vorrichtung zum Aufnehmen und Vakuumabdichten wenigstens eines Behältnisses (3) mit einer Ausgießöffnung und einem halsförmig ausgebildeten an die Ausgießöffung angrenzenden Wandungsbereich (3a) umfassend
- eine Dichtungseinrichtung (6) zum Abdichten der Öffnung in einem definierten Endzustand,
**gekennzeichnet durch**
- eine Aufnahme mit einem Einführbereich (2), in welchen ein an die Öffnung angrenzender Wandungsbereich (3a) des Behälters (3) wenigstens teilweise einführbar ist, und
- eine mit der Aufnahme zusammenwirkende Käfigeinrichtung (9, 10, 11), die eine Vielzahl von einander beabstandeten Einspannelementen (8), die jeweils in einer Richtung quer zur Einführrichtung in den Einführbereich (2) bringbar sind, derart hält, dass bei Kraftbeaufschlagung der Käfigeinrichtung (9, 10, 11) in Einführrichtung des Behältnisses (3) in den definierten Endzustand die Einspannelemente (8) aus einer den Einführbereich (2) im Wesentlichen freigebenden Position in eine in den Einführbereich (2) hineinragende Position geführt werden,
wobei ein im wesentlichen zylindrisch ausgebildeter Aufnahmekörper (1) eine Dichtungseinrichtung (6), insbesondere in Form eines Dichtungsringes, aufweist, und
wobei ein die Ausgießöffnung des Halses (3a) definierender Stirnrand (7) im eingeführten Endzustand, auf die Dichtungseinrichtung (6) drückt, so dass die Ausgießöffnung folglich abgedichtet ist.

2. Vorrichtung nach Anspruch 1, ferner **dadurch gekennzeichnet, dass** die Käfigeinrichtung (9, 10, 11) einen entlang der Einführrichtung verschiebbaren Schlitten (9) und eine fest angeordnet Führungsoberfläche (11) umfasst, zwischen denen die Einspannelemente (8) gehalten werden.

3. Vorrichtung nach Anspruch 1 oder 2, ferner **dadurch gekennzeichnet, dass** die Einspannelemente Kugeln (8) sind.

4. Vorrichtung nach einem der vorstehenden Ansprüche, ferner **dadurch gekennzeichnet, dass** die Käfigeinrichtung (9, 10, 11) zur Führung der Einspannelemente (8) eine Führungsoberfläche (11) aufweist, die Teil eines den Einführbereich (2) begrenzenden Aufnahmekörpers (1), insbesondere eines Aufnahmerings oder -Aufnahmezylinders, ist.

5. Vorrichtung nach einem der vorstehenden Ansprüche, ferner **dadurch gekennzeichnet, dass** die Käfigeinrichtung (9, 10, 11) zur Führung der Einspannelemente (8) eine Führungsoberfläche (11) aufweist, welche eine Verjüngung des Einführbereichs (2) in Einführrichtung bewirkt .

6. Vorrichtung nach einem der vorstehenden Ansprüche, ferner **dadurch gekennzeichnet, dass** die Käfigeinrichtung (9, 10, 11) und/oder die Einspannelemente (8) derart ausgebildet sind, dass die Einspannelemente (8) in am Hals (3a) ausgebildete Nuten und/oder zwischen Vorsprüngen (14a, 14b) des einzuführenden Behältnisses (3) einrastbar sind.

7. Vorrichtung nach einem der vorstehenden Ansprüche, ferner **dadurch gekennzeichnet, dass** der Einführbereich (2) zur Aufnahme eines in Bezug auf die Einführrichtung rückseitig einführbaren Vakuumsystems ausgebildet ist.

8. Vorrichtung nach einem der vorstehenden Ansprüche, ferner **gekennzeichnet durch** eine dem Behältnis (3) zugeordnete Mitnahmeeinrichtung (13) zur Kraftbeaufschlagung der Käfigeinrichtung (9, 10, 11) bei Bewegung des Behältnisses (3) in Einführrichtung.

9. Vorrichtung nach einem der vorstehenden Ansprüche, ferner **gekennzeichnet durch** eine von außen über das einführbare Behältnis (3) stülpbare Vakuumglocke (15).

10. Vorrichtung nach einem der vorstehenden Ansprüche, ferner **gekennzeichnet durch** eine einer von außen über das einführbare Behältnis (3) stülpbaren Vakuumglocke (15) und/oder von außen einbringbaren Führungselementen zugeordneten Mitnahmeeinrichtung (16) zur Kraftbeaufschlagung der Käfigeinrichtung (9, 10, 11) bei Bewegung der Vakuumglocke (15) und/oder von außen einbringbaren Führungselementen in Einführrichtung.

11. Vorrichtung nach einem der vorstehenden Ansprüche, ferner **dadurch gekennzeichnet, dass** die Käfigeinrichtung (9, 10, 11) unter einer der Einführrichtung entgegengesetzt gerichteten Vorspannung gehalten ist.

12. Anlage zum Vakuumbeschichten der inneren und/oder äußeren Oberflächen wenigstens eines Behältnisses (3), insbesondere eines flaschenförmigen Behältnisses (3), **gekennzeichnet durch** wenigstens eine Vorrichtung nach einem der vorstehenden Ansprüche.

## Claims

1. A device for receiving and vacuum-sealing at least one container (3) with a pouring opening and a wall area (3a) constructed in the form of a neck and adjoining the pouring opening, comprising
- a sealing means (6) for sealing the opening in a defined final state,
**characterised by**
- a receptacle with an insertion area (2), into which a wall area (3a) of the container (3) adjoining the opening may be inserted at least in part, and
- a cage means (9, 10, 11) interacting with the receptacle, which cage means (9, 10, 11) holds a plurality of mutually spaced clamping elements (8), which may in each case be brought into the insertion area (2) in a direction perpendicular to the insertion direction, in such a way that, when force is applied to the cage means (9, 10, 11) in the direction of insertion of the container (3) into the defined final state, the clamping elements (8) are guided from a position in which they leave the insertion area (2) substantially free into a position in which they protrude into the insertion area (2),
a receiving member (1) of substantially cylindrical construction comprising a sealing means (6), in particular in the form of a sealing ring,
and
an end wall (7) which defines the pouring opening of the neck (3a) pressing on the sealing means (6) in the inserted final state, such that the pouring opening is sealed as a result.

2. A device according to claim 1, further **characterised in that** the cage means (9, 10, 11) comprises a carriage (9) displaceable in the insertion direction and a fixedly arranged guide surface (11), between which components the clamping elements (8) are held.

3. A device according to claim 1 or claim 2, further **characterised in that** the clamping elements are balls (8) .

4. A device according to any one of the preceding claims, further **characterised in that** the cage means (9, 10, 11) comprises a guide surface (11) for guiding the clamping elements (8), which guide surface (11) is part of a receiving member (1), in particular a receiving ring or receiving cylinder, defining the insertion area (2).

5. A device according to any one of the preceding claims, further **characterised in that** the cage means (9, 10, 11) comprises a guide surface (11) for guiding the clamping elements (8), which guide surface (11) brings about tapering of the insertion area (2) in the insertion direction.

6. A device according to any one of the preceding claims, further **characterised in that** the cage means (9, 10, 11) and/or the clamping elements (8) are constructed in such a way that the clamping elements (8) may engage in grooves formed on the neck (3) and/or between projections (14a, 14b) of the container (3) to be inserted.

7. A device according to any one of the preceding claims, further **characterised in that** the insertion area (2) is constructed to receive a vacuum system insertable from the rear relative to the insertion direction.

8. A device according to any one of the preceding claims, further **characterised by** a driving means (13) associated with the container (3) for applying force to the cage means (9, 10, 11) on movement of the container (3) in the insertion direction.

9. A device according to any one of the preceding claims, further **characterised by** a vacuum bell (15) which may be drawn from the outside over the insertable container (3).

10. A device according to any one of the preceding claims, further **characterised by** a driving means (16) associated with a vacuum bell (15) which may be drawn from the outside over the insertable container (3) and/or with guide elements introducible from outside, said driving means (16) being provided for applying force to the cage means (9, 10, 11) on movement in the insertion direction of the vacuum bell (15) and/or of guide elements introducible from the outside.

11. A device according to any one of the preceding claims, further **characterised in that** the cage means (9, 10, 11) is held under pretension directed in the opposite direction from the insertion direction.

12. An installation for vacuum coating the inner and/or outer surfaces of at least one container (3), in particular a bottle-shaped container (3), **characterised by** at least one device according to any one of the preceding claims.

## Revendications

1. Dispositif pour la réception et pour rendre étanche au moins un récipient (3) avec une ouverture pour versement et une zone de paroi (3a) adjacente à l'ouverture pour versement, en forme de col, comprenant
- un dispositif d'étanchéité (6) pour rendre étanche l'ouverture en un état final défini,
**caractérisé par**
- une réception avec une zone de mise en place (2), dans laquelle une zone de paroi (3a) adjacente à l'ouverture, du récipient (3) peut être au moins partiellement mise en place, et
- un dispositif de logement (9, 10, 11)travaillant en association avec la réception, qui supporte un certain nombre d'éléments de tension (8) distants l'un de l'autre, qui peuvent être mis chaque fois, dans une direction perpendiculaire à la direction de mise en place dans la zone de mise en place (2), de sorte que lors de l'intervention de la force du dispositif de logement (9, 10, 11) dans la direction de la mise en place du récipient (3), dans l'état final défini, les éléments de tension (8) sont amenés depuis une position libérant essentiellement la zone de mise en place (2), en une position dépassant dans zone de mise en place (2), où un corps de réception (1) formé de manière essentiellement cylindrique présente un dispositif d'étanchéité (6), en particulier sous forme d'un joint d'étanchéité, et
où un bord frontal (7), définissant l'ouverture pour versement du col (3a) est pressé en un état final mis en place sur le dispositif d'étanchéité (6), de sorte que l'ouverture pour versement est par conséquent, rendue étanche.

2. Dispositif selon la revendication 1, **caractérisé en ce que** le dispositif de logement (9, 10, 11) comprend un chariot (9) pouvant être glissé le long de la direction de mise en place et une surface de guide (11) fixe, entre lesquels les éléments de tension (8) sont maintenus.

3. Dispositif selon la revendication 1 ou 2, **caractérisé en ce que** les éléments de tension (8) sont des sphères (8).

4. Dispositif selon l'une des revendications précédentes, **caractérisé en ce que** le dispositif de logement (9, 10, 11) présente pour le guide des éléments de tension (8), une surface de guide (11), qui est une partie d'un corps de réception (1) limitant une zone de mise en place (2), en particulier un anneau ou un cylindre de réception.

5. Dispositif selon l'une des revendications précédentes, **caractérisé en ce que** le dispositif de logement (9, 10, 11) présente pour le guide des éléments de tension (8), une surface de guide (11), qui agit par rétrécissement de la zone de mise en place (2) dans la direction de mise en place.

6. Dispositif selon l'une des revendications précédentes, **caractérisé en ce que** le dispositif de logement (9, 10, 11) et/ou les éléments de tension (8)sont formés de sorte que les éléments de tension (8) peuvent s'enclencher dans les rainures formées sur le col (3a) et/ou entre des saillies (14a, 14b) du récipient (3) à mettre en place.

7. Dispositif selon l'une des revendications précédentes, **caractérisé en ce que** la zone de mise en place (2) est formée pour la réception d'un système de mise sous vide, pouvant être introduit sur la face arrière par rapport au dispositif de mise en place.

8. Dispositif selon l'une des revendications précédentes, **caractérisé par** un dispositif de verrouillage (13) disposé sur le récipient (3) pour l'intervention de la force du dispositif de logement (9, 10, 11) lors du mouvement du récipient (3) en direction de la mise en place.

9. Dispositif selon l'une des revendications précédentes, **caractérisé par** une cloche de vide (15) pouvant être pénétrée de l'extérieur, par le récipient (3) à mettre en place.

10. Dispositif selon l'une des revendications précédentes, **caractérisé par** une cloche de vide (15) pouvant être pénétrée de l'extérieur, par le récipient (3) à mettre en place et/ou un dispositif de verrouillage (16), coordonné aux éléments de guide introduisibles de l'extérieur, pour l'intervention de la force du dispositif de logement (9, 10, 11) lors du mouvement de la cloche de vide (15) et/ou des éléments de guide introduisibles de l'extérieur dans la direction de mise en place.

11. Dispositif selon l'une des revendications précédentes, **caractérisé en ce que** le dispositif de logement (9, 10, 11) est maintenu sous une prétension dirigée contre la direction de mise en place.

12. Installation pour la mise sous vide des surfaces internes et/ou externes d'au moins un récipient (3), en particulier d'un récipient (3) de type bouteille, **caractérisé par** au moins un dispositif selon l'une des revendications précédentes.
